(19) Europäisches Patentamt
European Patent Office
Office européen des brevets

(11) Veröffentlichungsnummer: **0 001 997**
**B1**

(12) # EUROPÄISCHE PATENTSCHRIFT

(45) Veröffentlichungstag der Patentschrift: **11.02.81**

(51) Int. Cl.³: **G 03 F 7/10**, C 08 F220/10

(21) Anmeldenummer: **78101248.9**

(22) Anmeldetag: **28.10.78**

(54) **Elektronenstrahlvernetzbare Resistlacke.**

(30) Priorität: **10.11.77 DE 2750285**

(43) Veröffentlichungstag der Anmeldung: **30.05.79 (Patentblatt 79/11)**

(45) Bekanntmachung des Hinweises auf die Patenterteilung: **11.02.81 Patentblatt 81/06**

(84) Benannte Vertragsstaaten: **DE FR GB NL**

(56) Entgegenhaltungen:
**DE - A - 2 234 511**
**FR - A - 1 394 424**
**FR - A - 1 558 014**
**FR - A - 2 316 257**

(73) Patentinhaber: **BAYER AG**
**Zentralbereich Patente, Marken und Lizenzen**
**D-5090 Leverkusen 1, Bayerwerk (DE)**

(72) Erfinder: **Rosenkranz, Hans Jürgen, Dr.**
**Heinrich-Kauert-Weg 9**
**D-4150 Krefeld (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 001 997 B1

Imprimerie Jouve, 17, rue du Louvre, 75001 Paris, France

# Elektronenstrahlvernetzbare Resistlacke

Durch UV-Licht vernetzende Polymere, die als Resistlack verwendet werden können, sind bekannt, z.B. gegebenenfalls abgewandelte Polyvinylcinnamate und Polymere, die Chalcon- oder Stilben-Gruppen enthalten. Viele Polymere, z.B. synthetische Kautschuke, lassen sich durch UV-Licht vernetzen, wenn ihnen bestimmte Bisazido-Verbindungen zugesetzt werden. Einen Überblick über lichtvernetzende Materialien gibt J. Kosar, « Light Sensitive Systems », John Wiley & Sons, New York - London - Sydney 1965.

Aus der französischen Patentschrift 2 316 257 sind photovernetzbare Polymere bekannt, deren sensible Gruppe der Formel

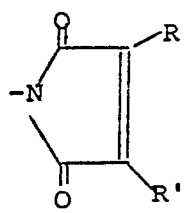

entspricht, worin

R = aromatischer Rest, R= = Wasserstoff, Halogen, Cyan oder Alkyl ist, oder R und R′ je ein Alkyl mit maximal 4 Kohlenstoffatomen ist, oder R und R′ zusammen die restlichen Ringglieder eines Kohlenstoffrings mit 5 oder 6 Kohlenstoffatomen bilden. Die freie Valenz des Stickstoffs ist an ein Polymergerüst gebunden.

Lichtvernetzende Polymere — im folgenden Resistsysteme — liefern bei Einwirkung von UV-Licht unlösliche resistente Überzüge. Resistsysteme können daher in dünner Schicht auf ein Substrat aufgetragen, bildmäßig belichtet und mit organischen Lösungsmitteln durch Herauslösen der unbelichteten Teile « entwickelt » werden. Da die unbelichteten Teile herausgelöst werden, spricht man auch von negativen Resisten.

Man hat versucht, Resistsysteme auch mit Elektronenstrahlen zu härten, jedoch waren die Ergebnisse bisher für die Praxis unbrauchbar.

Da aber mit Elektronenstrahlen eine höhere Auflösung bei bildmäßig belichteten Schichten erreicht wird als etwa mit UV-Licht, sind für diese Art der Vernetzung geeignete Resistlacke für die weitere Verkleinerung von gedruckten Schaltungen und integrierten elektronischen Bauteilen erforderlich.

Gegenstand der Erfindung sind demnach elektronenstrahlvernetzbare Resistlacke, deren wirksamer Bestandteil ein Copolymerisat aus

A) 10-90 Mol-% eines $C_1$-$C_{20}$-Alkylesters der Acrylsäure und/oder Methacrylsäure ;

B) 0-50 Mol-%, bevorzugt 10-50 Mol eines Hydroxylgruppen enthaltenden $C_1$-$C_{10}$-Alkylesters der Acryl- und/oder Methacrylsäure, und

C) 3-70 Mol-%, bevorzugt 10-50 Mol eines Monomeren der Formeln

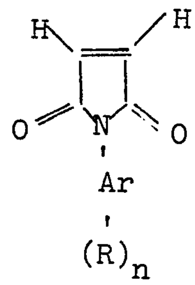

(1)

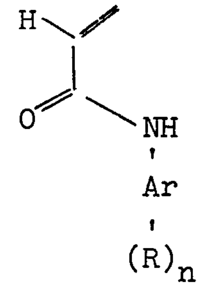

(2)

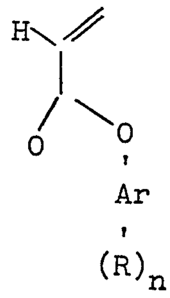

(3)

ist,

in denen

Ar einen bis zu 6-wertigen Arylrest, der 6-18 Kohlenstoffatome enthält und aus 1-3 Ringen besteht ;

R Wasserstoff ; $C_1$-$C_{12}$-Alkyl ; Halogen (Chlor, Brom) ; O-Alkyl ($C_1$-$C_{12}$) ; O-$(CH_2$-$CH_2$-$O)_{1-4}$-H ; O-$(CHCH_3$-$CH_2O)_{1-4}$-H ; Nitro ; -COOH ; -CHO ; -COO Alkyl ($C_1$-$C_{12}$) ; -CN ; $-CONH_2$ ; -CONH-Alkyl ($C_1$-$C_{12}$) ; -CON-(Alkyl ($C_1$-$C_{12}$))$_2$ oder -NHCO Alkyl ($C_1$-$C_{12}$), und

n eine ganze Zahl von 1-5

bedeuten.

Die den erfindungsgemäßen Resistlacken zugrundeliegenden Polymerisate können zusätzlich 0-30 Mol einer ungesättigten Carbonsäure, 0-40 Mol Acrylamid, Methacrylamid oder deren N-Alkylsubstitutionsprodukte und/oder 0-70 Mol Styrol, α-Methylstyrol, Acrylnitril, Vinylacetat, Vinylpropionat, Vinylalkyläther mit 1-8 Kohlenstoffatomen im Alkylrest, Methacrylnitril, Allylacetat, Vinylchlorid, Vinylidenchlorid, Maleinimid oder Maleinanhydrid einpolymerisiert enthalten.

Monomere A sind bevorzugt

Acrylsäuremethylester, Acrylsäureethylester, Acrylsäurebutylester, Acrylsäurepropylester, Acrylsäureethylhexylester, Acrylsäuredodecylester, Methacrylsäuremethylester, Methacrylsäureethylester, Methacrylsäurepropylester, Methacrylsäurebutylester, Methacrylsäuredodecylester.

Monomere B sind bevorzugt

Acrylsäurehydroxyethylester, Acrylsäurehydroxypropylester, Methacrylsäurehydroxyethylester, Methacrylsäurehydroxypropylester.

Als ungesättigte Carbonsäuren kommen in Frage :

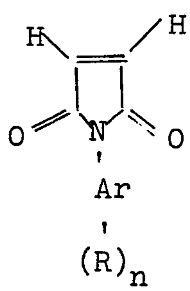

(1)

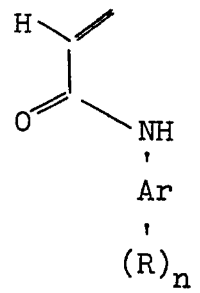

(2)

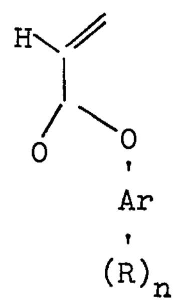

(3)

Acrylsäure, Methacrylsäure, Maleinsäure, Fumarsäure.

Monomere C sind solche, die durch die Formeln 1-3 charakterisiert werden.

Es handelt sich also um N-Arylderivate des Maleinimids und des Acrylamids, sowie um bestimmte Arylester der Acrylsäure. In den obigen Formeln bedeuten

Ar einen bis zu 6-wertigen Arylrest, der 6-18 Kohlenstoffatome enthält und aus 1-3 Ringen besteht ;

R = Wasserstoff $C_1$-$C_{12}$ Alkyl ; Halogen (Chlor, Brom) ; O-Alkyl ($C_1$-$C_{12}$) ; O-$(CH_2CH_2-O)_{1-4}$-H ; O-$(CHCH_3-CH_2O)_{1-4}$-H ; Nitro ; -COOH ; -CHO ; -COO Alkyl ($C_1$-$C_{12}$) ; -CN ; -$CONH_2$ ; -CONH-Alkyl ($C_1$-$C_{12}$) ; -CON-(Alkyl ($C_1$-$C_{12}$))$_2$ ; -NHCO Alkyl ($C_1$-$C_{12}$) und

n eine ganze Zahl von 1-5.

Beispiele für besonders geeignete Arylreste sind : Phenyl, Biphenyl, Anthracenyl, Phenanthryl, Naphthyl.

Besonders bevorzugt sind diese Reste substituiert mit 1-5 Halogenatomen, insbesondere Chloratomen.

Diese Monomeren werden (im Unterschied zum Gegenstand der französischen Patentschrift 2 316 257) durch Öffnen der C = C-Bindung einpolymerisiert.

Monomere gemäß Formel (1) können hergestellt werden nach US-PS 3 433 801. Beispiele für diese Monomere sind : Phenylmaleinimid, p-Methylphenylmaleinimid, 2,4-Dimethylphenylmaleinimid, p-Methoxyphenylmaleinimid, 3,5-Dimethoxyphenylmaleinimid, 3,4-Dimethoxyphenylmaleinimid, p-Chlorphenylmaleinimid, 3,4-Di-Chlorphenylmaleinimid, 2,4,5-Trichlorphenylmaleinimid, m-Methoxyphenylmaleinimid, 2,4-Dimethoxy-5-Chlorphenylmaleinimid, 2,4,6-Tri-Chlorphenylmaleinimid, 3-Chlor-4-methoxyphenylmaleinimid, 2-Methoxy-5-chlorphenylmaleinimid, p-Nitrophenylmaleinimid, m-Nitrophenylmaleinimid, p-Acetylphenylmaleinimid, p-Acetylaminophenylmaleinimid, p-Carboxymethylphenylmaleinimid, Naphthylmaleinimid, 5-Methoxynaphthylmaleinimid.

Monomere der Formel (2) können analog nach Umsetzung der Aminoverbindungen, die zur Herstellung der obengenannten Maleinimide verwendet werden, mit Acrylsäurechlorid erhalten werden. Eine typische Verfahrensweise ist beispielsweise in « Organikum », VEB-Deutscher Verlag d. Wissenschaften, Berlin 1973, Seite 453 beschrieben.

Beispiele sind : N-Phenylacrylamid, p-Methylphenylacrylamid, p-Methoxyphenylacrylamid, 3,5-Dimethoxyphenylacrylamid, p-Chlorphenylacrylamid, 2,4-Dichlorphenylacrylamid, 2,4,5-Trichlorphenylacrylamid, 2,4-Dimethoxy-5-Chlorphenylacrylamid, 2-Chlor-4-methoxyphenylacrylamid, p-Nitrophenylacrylamid, p-Acetylphenylacrylamid, N-Naphthylacrylamid.

Monomere der Formel (3) können ebenfalls nach « Organikum », VEB-Deutscher Verlag d. Wissenschaften, Berlin 1973, Seite 446 hergestellt werden.

Beispiele sind : Acrylsäurephenylester, Acrylsäure-p-chlorphenylester, Acrylsaüre-3,4-Dichlorphenylester, Acrylsäure-3,4,5-Dichlorphenylester, Acrylsäure-2,3,4,5,6-pentachlorphenylester, Acrylsäure-4-methoxy-5-chlorphenylester.

Die den erfindungsgemäßen Resistsystemen zugrundeliegenden Polymeren können durch radikalische Polymerisation der Monomeren in Lösung, in Masse, in Suspension oder in Emulsion erzeugt werden. Hierbei können übliche Initiatoren wie Peroxide, Azoverbindungen oder Redox-Systeme Verwendung finden. Ebenso kann die Polymerisation in Gegenwart geeigneter Photoinitiatoren durch Licht ausgelöst werden ; Voraussetzung ist hierbei allerdings, daß kein Licht verwendet wird, das bei dem entstehenden Polymeren bereits eine Vernetzung herbeiführen kann.

Bei der Polymerisation können das Molekulargewicht reduzierende Zusätze in Mengen von 0,01-5 Mol-% zugesetzt werden. Solche Zusätze sind beispielsweise n-Butylmerkaptan, tert.- oder n-Dodecylmerkaptan, Ethylenglykol-Dimerkaptoacetat, Pentaerythrittrimerkaptoacetat, Trioglykol, Thioglycerin, Thioglykolsäure, Tetrachlorkohlenstoff.

Die Polymerisate stellen feste, lösliche Harze dar mit einem bevorzugten Molekulargewicht von 5000 bis 500000. Sie können in üblichen Lacklösungsmitteln gelöst und in dieser Form auf die gewünschten Substrate aufgebracht werden, um dort nach Entfernen der Lösungsmittel den Resist-Film zu bilden.

Ein typisches Polymerisat im Sinne der Erfindung kann wie folgend hergestellt werden : Ein Acryl- und/oder Methacrylsäurealkylester, ein Acryl- und/oder Methacrylsäureoxyalkylester, sowie ein Monomeres gemäß Formel (1) - (3), werden zu annähernd gleichen Teilen in einem für Vinylpolymerisationen gebraüchlichen Lösungsmittel gelöst mit Hilfe eines organischen Peroxyds polymerisiert. Die erhaltene Harzlösung kann direkt (gegebenenfalls nach Filtration) zur Erzeugung des Resist-Filmes verwendet werden. Das Polymere kann auch ausgefällt, isoliert und gereinigt werden, bevor es zum Resist-Film weiterverarbeitet wird.

Das erfindungsgemäße Resistsystem kann außer dem Polymerisat und einem geeigneten Lösungsmittel in der Regel noch weitere übliche Bestandteile enthalten, z.B. können hydroxylgruppenhaltige Polymerisate oder Polykondensate zugesetzt werden, sowie Sensibilisatoren, Photoinitiatoren oder Farbstoffe.

Zur Erzeugung der Resist-Schicht können praktisch alle Lösungsmittel verwendet werden, in denen die erfindungsgemäßen Polymeren gut löslich sind. Geeignet sind chlorierte Kohlenwasserstoffe, höhere Alkohole, Ester und aromatische Kohlenwasserstoffe.

Als Substrate können beispielsweise alle in der Elektronikindustrie verwendeten Materialien benutzt werden, wie Metallfolien aus Kupfer, Aluminium, Zink, Magnesium, Stahl und Trägerflächen, z.B. aus Silicium zur Halbleitererzeugung. Je nach Konzentration der Polymerlösung können auf diesen Substraten Schichten praktisch beliebiger Schichtdicke erzeugt werden. Im Bereich der Mikroelektronik werden Schichtdicken von weniger als 5 μm benutzt, um eine gute Abbildung auch feinster Details zu erreichen.

Die erfindungsgemäßen Resistsysteme werden bevorzugt durch Elektronenstrahlen vernetzt. Es genügen bereits sehr geringe Strahlungsdosen von $10^{-6}$ bis $10^{-3}$ Coulomb/$cm^2$. Üblicherweise werden Elektronenstrahlen einer Energie von 10000-100000 eV verwendet. Andere besonders energiereiche Strahlung (Röntgenstrahlen, γ-Strahlen) kann prinzipiell verwendet werden. Bevorzugt ist aber Elektronenstrahlung.

Ferner ist eine Vernetzung durch Einwirkung kurzwelligen UV-Lichts zu erzielen. Beispielsweise führt das Licht einer Quecksilbermitteldruck- oder Quecksilberniederdrucklampe, aber auch der kurzwellige Anteil einer Auecksilberhochdruck- oder Kohlenbogenlampe, also Wellenlängenbereich $< 320$ nm, in kurzer Zeit zu einer Vernetzung.

Nach dem Bestrahlen und damit der Vernetzung der Resist-Schicht kann mit einem Lösungsmittel « entwickelt » werden. Welche Lösungsmittel hier besonders geeignet sind, hängt vor allem von der Zusammensetzung des Polymeren ab. Ein optimales Lösungsmittel kann durch einfache Tests ermittelt werden. In der Regel sind aromatische Kohlenwasserstoffe oder Chlorkohlenwasserstoffe oder Ester geeignet. Enthalten die Polymere eine polymerisierte ungesättigte Säure wie Acrylsäure oder Methacrylsäure, so kann auch mit wäßrigem Alkali entwickelt werden. In der Regel wird dann eine 1-2 % ige Sodalösung verwendet.

Zur Prüfung der Qualität der Resist-Schichten sowie der bildmäßig entwickelten vernetzten Überzüge auf dem Trägermaterial kann man dem Resistsystem einen üblichen Farbstoff zufügen. Praktisch alle in organischen Lösungsmitteln löslichen Farbstoffe sind verwendbar, sowie organische und anorganische Farbpigmente.

In der Regel werden die Substrate mit bildmäßig entwickelten Resist-Filmen geätzt oder galvanisch mit Metallen beschichtet (z.B. zur Herstellung gedruckter Schaltungen). Die erfindungsgemäßen Resiste zeichnen sich dabei durch besondere Unempfindlichkeit aus. Ebenso haften sie gut und ermöglichen feinste Details und Strukturen wiederzugeben. Nach dem Ätzen oder der Galvanisierung kann der bildmäßige Resistfilm mit geeigneten Lösemitteln vom Substrat entfernt werden. Geeignete Lösungsmittel lassen sich durch einfache Tests ermitteln. Geeignet sind beispielsweise Dimethylformamid, halogenierte Kohlenwasserstoffe, organische Säuren sowie wäßriges Alkali.

Die erfindungsgemäßen Resistsysteme eignen sich zur Herstellung von integrierten elektronischen Bausteinen, aber auch für Reliefbilder und Druckformen für den Hoch-, Tief- oder Flachdruck, z.B. für Offsetdruck, Siebdruck und lithografische Druckplatten und Autotypie.

Beispiel 1

In einem 250-ml-Dreihals-Rundkolben mit Rückflußkühler, Rührer und Tropfrichter wurden 50 g Methylethylketon unter Einleiten von Stickstoff zur Siedetemperatur erhitzt. Hierzu wurde innerhalb einer Stunde eine Mischung von 6,7 g (0,05 Mol) Oxyethylacrylat, 6,4 g (0,05 Mol) Butylacrylat, 0,27 g Azoisobuttersäuredinitril, 13,8 g (0,05 Mol) 2,4,5-Trichlorphenylmaleinimid gelöst in 40 g Methylethylketon zugetropft. Im Anschluß daran wurde unter weiterem Sieden eine Lösung von 0,14 g Azoisobuttersäuredinitril gelöst in 20 g Methyläthylketon innerhalb einer weiteren Stunde zugetropft. Nach einer weiteren Stunde sieden am Rückfluß wurde die erhaltene Polymerlösung eingeengt, in Methylenehlorid gelöst, filtriert und anschließend in Petroläther ausgefällt. Das trockene Polymere wies einen Chlorgehalt von 19,6 % auf (Theorie : 19,7 % Cl).

Das Polymer wurde erneut in einem Gemisch aus Methylenchlorid und Methylglykolacetat gelöst und in einer ca. 3 μm dicken Schicht auf eine kupferkaschierte Polyesterfolie aufgebracht. Ein 2 × 2 cm großes Stück dieser Folie wurde in ein Elektronenmikroskop eingebracht und dort ein Teil der Oberfläche einem Elektronenstrahl einer Energie von 20000 eV bzw. einer Stromstärke von 50 nA so lange ausgesetzt, bis eine Strahlendosis von $10^{-4}$ Coulomb/$cm^2$ eingewirkt hatte. Nun wurde das bestrahlte Folienstück mit Toluol « entwickelt ». An den vom Elektronenstrahl belichteten Teilen der Folie blieb die Polymerschicht scharf umrissen erhalten. Bei einer anschließenden Ätzung in Eisen-III-Chlorid-Lösung erwies sich der vernetzte Polymerfilm als absolut resistent ; eine vollkommene Auflösung des ungeschützten Kupfers hatte keinerlei Beschädigung des Resistlackfilms und des darunterliegenden Kupfers zur Folge.

Beispiel 2

Analog Beispiel 1 wurde aus 9,6 g Butylacrylat, 10,5 g Oxyethylacrylat, 0,35 g Azoisobuttersäuredinitril und 15,2 g p-Methoxyphenylmaleinimid in insgesamt 250 g Methylethylketon ein Polymeres bereitet und durch Ausfällen aus Petroläther gereinigt.

Ein dünner Film dieses Polymeren vernetzte ebenfalls unter den in Beispiel 1 angegebenen Bestrahlungsbedingungen. An unbelichteten Stellen konnte der Film mit Benzol aufgelöst werden.

Beispiel 3

Analog Beispiel 1 wurde aus 9,6 g Butylacrylat, 10,5 g Oxyethylacrylat, 0,35 g Azoisobuttersäuredinitril und 15,3 g p-Nitrophenylmaleinimid, gelöst in insgesamt 250 g Methylethylketon, ein Polymeres bereitet. Bei Bestrahlung wie in Beispiel 1 vernetzte der Film bei einer Strahlendosis von 5 × $10^{-4}$ Coulomb/$cm^2$.

Beispiel 4

In der in Beispiel 1 beschriebenen Apparatur wurde unter Überleiten von Stickstoff eine Mischung von 20 g Methylethylketon, 9,6 g Butylacrylat, 10,5 g Oxyethylacrylat und 18,4 g p-Carboxyethylphenylmaleinimid zum Rückfluß erhitzt. Innerhalb 3 Stunden wurde hierzu die Lösung von 0,39 g Azoisobuttersäuredinitril in 20 g Methylethylketon getropft. Nach einer weiteren Stunde Sieden unter Rückfluß wurde das Polymere, wie Beispiel 1 beschrieben, aufgearbeitet. Eine dünne Schicht dieses Polymeren vernetzte unter den in Beispiel 1 angegebenen Bedingungen.

Beispiel 5

Wie in Beispiel 1 wurden 9,6 g Butylacrylat, 10,5 g Oxyethylacrylat, 0,4 g Azoisobuttersäuredinitril und 20,07 g 2,4-Dimethoxy-5-Chlorphenylmaleinimid, gelöst in insgesamt 250 g Methylethylketon, polymerisiert.

Beispiel 6

Wie in Beispiel 1 wurden 9,6 g Butylacrylat, 10,5 g Oxyethylacrylat, 0,37 g Azoisobuttersäuredinitril und 17,82 g 3-Chlor-4-Methoxyphenylmaleinimid, gelöst in insgesamt 300 g Methylethylketon, polymerisiert.

Beispiel 7

Wie in Beispiel 1 wurden 9,6 g Butylacrylat, 10,5 g Oxyethylacrylat, 0,35 g Azoisobuttersäuredinitril und 15 g α-Naphthylmaleinimid, gelöst in insgesamt 60 g Methylethylketon, polymerisiert. Eine bildmäßige Bestrahlung unter den in Beispiel 1 beschriebenen Bedingungen fürhrte zu einem durch Toluol entwickelbaren Bild.

Beispiel 8

Das in Beispiel 5 unter Verwendung von 2,4-Dimethoxy-5-Chlorphenylmaleinimid hergestellte Polymere wurde in dünner Schicht auf eine Kupfer-kaschierte Polyesterfolie aufgebracht. Ein 2 × 2 cm großes Stück dieser Folie wurde in ein Elektronenmikroskop eingebracht und dort ein Teil der Oberfläche einem Elektronenstrahl einer Energie von 20000 eV bzw. einer Stromstärke von 50 nA so lange ausgesetzt, bis eine Strahlendosis von $10^{-4}$ Coulomb/$cm^2$ eingewirkt hatte. Nun wurde das bestrahlte Folienstück mit Toluol « entwickelt ». An den vom Elektronenstrahl belichteten Teilen der Folie blieb die Polymerschicht scharf umrissen erhalten. Bei einer anschließenden Ätzung in Eisen-III-Chlorid-Lösung erwies sich der vernetzte Polymerfilm als absolut resistent, und man erhielt ein sehr scharfes Ätzbild der bestrahlten Zone.

Beispiel 9

Wie in Beispiel 8 wurde das gemäß Beispiel 6 unter Verwendung von 3-Chlor-4-Methoxyphenylmaleinimid hergestellte Polymere in einem Elektronenmikroskop mit einem Elektronenstrahl bestrahlt. Auch hier genügte eine Strahlendosis von $10^{-4}$ Coulomb/$cm^2$, um die Polymerschicht zu völliger Ätzresistenz zu vernetzen. Auch die hier erhältlichen Ätzbilder zeichneten sich durch sehr gute Kantenschärfe aus.

Beispiel 10

Wie in Beispiel 8 wurde ein aus 9,6 g Butylacrylat, 10,5 g Oxyethylacrylat und 15,2 g p-Acetylphenylmaleinimid bereitetes Polymeres in einem Elektronenmikroskop der Einwirkung eines gebündelten Elektronenstrahls ausgesetzt. Auch hier genügte bei einer Spannung von 20 kV und einer Stromstärke von 10 nA eine Strahlendosis von $10^{-4}$ Coulomb/$cm^2$, um den Film zu vollkommener Ätzresistenz gegenüber Eisen-III-Chlorid-Lösung zu vernetzen.

Beispiel 11

Wie in Beispiel 1 beschrieben, wurde aus 9,6 g Butylacrylat und 10,4 g 2,4,5-Trichlorphenylmaleinimid in 100 g Methylethylketon ein Polymeres bereitet. Unter der Einwirkung eines Elektronenstrahls im Elektronenmikroskop vernetzte ein damit hergestellter Film unter den in Beispiel 8 angegebenen Bedingungen bei einer Strahlendosis von 8 × $10^{-4}$ Coulomb/$cm^2$. Auch dieser vernetzte Film zeichnete sich durch hohe Ätzresistenz aus.

Beispiel 12

Aus 9,6 g Butylacrylat und 7,8 g p-Chlorphenylmaleininimid und 0,17 g Azoisobuttersäuredinitril gelöst und in insgesamt 100 g Methylethylketon wurde analog Beispiel 1 ein Polymeres hergestellt. Nach der üblichen aufarbeitung wurde dieses Polymere zu gleichen Teilen mit einem anderen Vinylpolymeren, bestehend aus 46 Gew.-% Styrol, 31 Gew-% Butylacrylat und 23 Gew.-%

Hydroxypropylmethacrylat, abgemischt. Eine Lösung dieser Mischung in Methylenchlorid wurde in dünner Schicht auf einen Metallträger aufgebracht und wie in Beispiel 1 bildmäßig bestrahlt. Es wurde ein mit Ethanol entwickelbares Bild erhalten.

Beispiel 13

Wie in Beispiel 12 wurde das unter Mitverwendung von p-Chlorphenylmaleinimid hergestellte Polymere zu gleichen Teilen mit einem Polyester aus Trimethylolpropan, und Phthalsäureanhydrid mit einer OH-Zahl von 250 abgemischt. Ein Polymerfilm dieser Mischung ergab nach bildmäßiger Bestrahlung wie in Beispiel 12 ein mit Toluol entwickelbares Bild.

Beispiel 14

In der in Beispiel 1 beschriebenen Apparatur wurde aus gleichen Anteilen Methylmethacrylat und p-Methoxy-N-Phenylacrylamid in Methylethylketon als Lösungsmittel ein Vinylpolymeres hergestellt. Dieses Polymere wurde zu gleichen Teilen mit einem Vinylpolymeren, bestehend aus 46 Gew.-% Styrol, 31 Gew.-% Butylacrylat und 23 Gew.-% Hydroxypropylmethacrylat, abgemischt. ein dünner Film dieser Mischung auf einer Metalloberfläche vernetzte nach einer Bestrahlung wie in Beispiel 1.

Beispiel 15

In der in Beispiel 1 beschriebenen Apparatur wurden 50 g Toluol vorgelegt und unter Einleiten von Stickstoff zur Siedetemperatur erhitzt. Hierzu wurde innerhalb einer Stunde eine Mischung von 8,01 g (0,025 Mol) Pentachlorphenylacrylsäureester, 3,2 g (0,025 Mol) Butylacrylat, 3,4 g (0,025 Mol) Oxyethylacrylat, 0,15 g Benzoylperoxid und 50 g Toluol zugetropft. In einer weiteren Stunde wurde die Lösung von 0,08 g Benzoylperoxid gelöst in 10 g Toluol zugetropft. Nach einer weiteren Stunde wurde die Polymerlösung eingeengt und wie in Beispiel 1 aus Petroläther ausgefällt. Ein 1 μm dicker Film dieses Polymeren, aufgebracht auf eine kupferkaschierte Polyesterfolie, vernetzte unter der Einwirkung von Elektronenstrahlen im Elektronenmikroskop unter den in Beispiel 8 angegebenen Bedingungen bei einer Strahlendosis von $5 \times 10^{-5}$ Coulomb/cm$^2$.

**Anspruch**

Elektronenstrahlvernetzbare Resistlacke, deren wirksamer Bestandteil ein Copolymerisat aus

A) 10-90 Mol-% eines $C_1$-$C_{20}$-Alkylesters der Acrylsäure und/oder Methacrylsäure ;

B) 0-50 Mol-%, bevorzugt 10-50 Mol eines Hydroxylgruppen enthaltenden $C_1$-$C_{10}$-Alkylesters der Acryl- und/oder Methacrylsäure, und

C) 3-70 Mol-%, bevorzugt 10-50 Mol eines Monomeren der Formeln

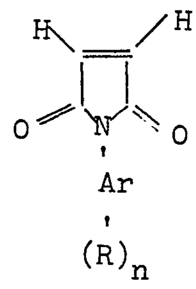
(1)

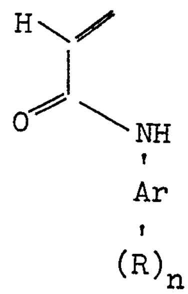
(2)

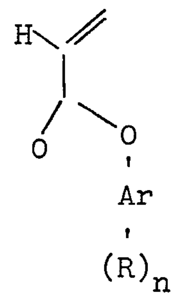
(3)

ist,
in denen

Ar einen bis zu 6-wertigen Arylrest, der 6-18 Kohlenstoffatome enthält und aus 1-3 Ringen besteht ;

R Wasserstoff ; $C_1$-$C_{12}$-Alkyl ; Halogen (Chlor, Brom) ; O-Alkyl ($C_1$-$C_{12}$) ; O-$(CH_2CH_2$-$O)_{1-4}$-H ; O-$(CHCH_3$-$CH_2O)_{1-4}$-H ; Nitro ; -COOH ; -CHO ; -COO Alkyl ($C_1$-$C_{12}$) ; -CN ; -$CONH_2$ ; -CONH-Alkyl ($C_1$-$C_{12}$) ; -CON-(Alkyl ($C_1$-$C_{12}$))$_2$ oder -NHCO Alkyl ($C_1$-$C_{12}$), und

n eine ganze Zahl von 1-5

bedeuten.

**Claim**

Resist lacquers crosslinkable by electron beams of which the active constituent is a copolymer comprising

A) 10 to 90 mole % of a $C_1$-$C_{20}$ alkyl ester of acrylic and/or methacrylic acid ;

B) 0 to 50 mole %, preferably 10 to 50 mole % of a hydroxyl-group-containing $C_1$-$C_{10}$ alkyl ester of acrylic and/or methacrylic acid, and

C) 3 to 70 mole %, preferably 10 to 50 mole % of a monomer of the formulae

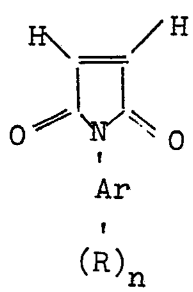
(1)

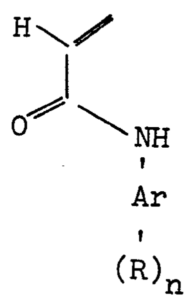
(2)

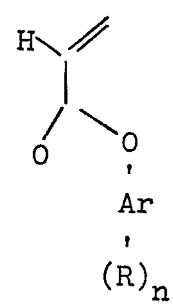
(3)

in which

Ar denotes an up to hexafunctional aryl radical which contains from 6 to 18 carbon atoms and consists of 1 to 3 rings ;

R denotes hydrogen ; $C_1$-$C_{12}$ alkyl ; halogen (chorine, bromine) ; O-alkyl ($C_1$-$C_{12}$) ; O-$(CH_2CH_2$-$O)_{1-4}$-H ; O-$(CHCH_3$-$CH_2O)_{1-4}$-H ; nitro ; -COOH ; -CHO ; -COO alkyl ($C_1$-$C_{12}$) ; -CN ; -$CONH_2$ ; -CONH-alkyl ($C_1$-$C_{12}$) ; -CON-(alkyl $C_1$-$C_{12})_2$ or -NHCO alkyl ($C_1$-$C_{12}$), and

n denotes an integer from 1 to 5.

**Revendication**

Vernis de réserve pouvant être réticulés par un flux d'électrons, dont le composant actif est un produit de copolymérisation de :

A) 10 à 90 moles % d'un ester d'alkyle en $C_1$ à $C_{20}$ d'acide acrylique et/ou d'acide méthacrylique,

B) 0 à 50 moles %, de préférence 10 à 50 moles % d'un ester d'alkyle en $C_1$ à $C_{10}$, porteur de groupes hydroxyle, d'acide acrylique et/ou d'acide méthacrylique, et

C) 3 à 70 moles %, de préférence 10 à 50 moles % d'un monomère de formules :

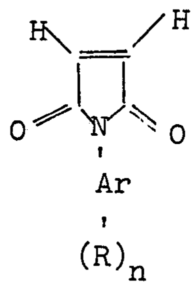

(1)

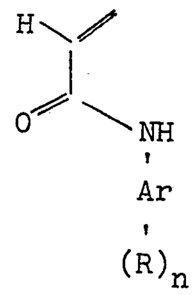

(2)

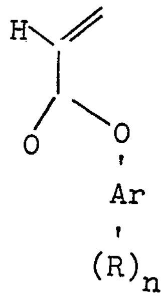

(3)

dans lesquelles

Ar est un reste aryle allant jusqu'à hexavalent, qui comprend 6 à 18 atomes de carbone et qui est constitué par 1 à 3 noyaux ;

R est l'hydrogène ; un groupe alkyle en $C_1$ à $C_{12}$ ; un halogène (chlore, brome) ; un groupe O-alkyle ($C_1$-$C_{12}$) ; O-$(CH_2CH_2-O)_{1-4}$-H ; O-$(CHCH_3$-$CH_2O)_{1-4}$-H ; nitro ; -COOH ; -CHO ; -COO-alkyle ($C_1$-$C_{12}$) ; -CN ; -$CONH_2$ ; -CONH-alkyle ($C_1$-$C_{12}$) ; -CON-(alkyle $(C_1$-$C_{12}))_2$ ou -NHCO-alkyle ($C_1$-$C_{12}$), et

n est un nombre entier de valeur 1-5.